# EUROPÄISCHE PATENTSCHRIFT

(11) **EP 3 704 400 B1**
(45) Veröffentlichungstag und Bekanntmachung des Hinweises auf die Patenterteilung: **26.07.2023**
(21) Anmeldenummer: 18782715.9
(22) Anmeldetag: 02.10.2018
(51) Int. Cl.: G01D 5/14, G01B 7/30, G01D 5/244, G01R 33/00, G01R 33/07

(54) **MAGNETFELDSENSOR UND VERFAHREN ZUR MONTAGE EINES MAGNETEN**
MAGNETIC FIELD SENSOR AND METHOD FOR MOUNTING A MAGNET
CAPTEUR DE CHAMP MAGNÉTIQUE ET PROCÉDÉ DE MONTAGE D'UN AIMANT

(30) Priorität: 03.11.2017 DE 102017219584
(43) Veröffentlichungstag der Anmeldung: 09.09.2020
(73) Patentinhaber: ZF Friedrichshafen AG, 88046 Friedrichshafen (DE)
(72) Erfinder: STRATMANN, Julian, 49152 Bad Essen (DE); KLANK, Michael, 49084 Osnabrück (DE); KRAHN, Stefan, 49074 Osnabrück (DE)
(74) Vertreter: ZF Friedrichshafen AG
(86) Internationale Anmeldenummer: PCT/EP2018/076856
(87) Internationale Veröffentlichungsnummer: WO 2019/086191

(56) Entgegenhaltungen:
- EP-A1- 0 617 260
- US-A1- 2004 100 357
- US-A1- 2008 231 262
- US-A1- 2009 016 811
- US-A1- 2012 025 810
- US-A1- 2015 168 124

## Beschreibung

Die Erfindung betrifft einen Magnetfeldsensor nach dem Oberbegriff des Patentanspruches 1, ein Verfahren nach dem Oberbegriff des Patentanspruches 7.

Aus der US 2012/0025810 A1 ist ein Magnetfeldsensor mit den Merkmalen des Oberbegriffes des Patentanspruches 1 bekannt. Hiernach ist die Magnetfeldachse parallel versetzt zu einer Bauteilachse angerordnet.

Der EP 0 617 260 A1 ist ein Magnetfeldsensor zu entnehmen, bei dem der Magnet derart in einem Bauteil aufgenommen ist, dass die Magnetfeldachse mit der Bauteilachse übereinstimmt.

Magnetfeldsensoren sind u. a. als Positionssensoren, insbesondere auch zur Messung einer Winkelposition bekannt. Magnetfeldsensoren bestehen aus zwei Sensorelementen, nämlich einem ersten Sensorelement, welches als Permanentmagnet ausgebildet ist und als Signalgeber wirkt, und einem zweiten Sensorelement, welches als Magnetfeld empfindliches Sensorelement ausgebildet ist und als Signalempfänger wirkt. Das zweite Sensorelement kann beispielsweise als Hall-Element ausgebildet sein.

Durch die ältere Anmeldung der Anmelderin mit dem Aktenzeichen 10 2017 208 410.3 wurde ein Magnetfeldsensor, bestehend aus einem Permanentmagneten als - Signalgeber und einem Sensorelement als Signalempfänger, bekannt, welcher in einem Kugelgelenk verbaut ist. Dabei befindet sich der Permanentmagnet in einer Ausnehmung, insbesondere einer Sacklochbohrung des Kugelzapfens, während das zweite Sensorelement, der Signalempfänger, in einem den Kugelzapfen aufnehmenden Gehäuse angeordnet ist. Bei Winkelbewegungen des Kugelzapfens gegenüber dem Gehäuse registriert das zweite Sensorelement eine Änderung des Magnetfeldes. Durch Auswertung dieses Änderungssignals kann auf die Winkelposition geschlossen werden.

Ein Problem bei derartigen Magnetfeldsensoren besteht darin, dass das Magnetfeld, welches vom Magneten erzeugt wird, Toleranz behaftet ist und Abweichungen vom Sollzustand, insbesondere Fehlstellungen der Achse des Magnetfeldes aufweisen kann. Eine solche Fehlstellung liegt dann vor, wenn die Achse des Magnetfeldes und die Achse des Magneten, welcher in einem beweglichen Bauteil angeordnet ist, nicht übereinstimmen, sondern einen Winkel miteinander bilden. Die Anzeige einer Winkelposition mit einem derart fehlerhaften Magnetfeld wäre dann ebenfalls mit einem Fehler bzw. einer Abweichung behaftet.

Eine Aufgabe der vorliegenden Erfindung besteht darin, die Messgenauigkeit eines Magnetfeldsensors der eingangs genannten Art zu verbessern.

Die Erfindung umfasst die Merkmale der unabhängigen Patentansprüche 1 und 7. Vorteilhafte Ausgestaltungen ergeben sich aus den Unteransprüchen.

Nach einem ersten Aspekt der Erfindung ist bei einem Magnetfeldsensor mit einem Magneten, einer Magnetachse, einem Magnetfeld und einer Magnetfeldachse vorgesehen, dass der Magnet derart in dem beweglichen Bauteil aufgenommen ist, dass die Magnetfeldachse weitestgehend mit der Bauteilachse übereinstimmt. Unter Magnetachse wird die geometrische Achse des Magnetkörpers verstanden. Der Magnet erzeugt ein Magnetfeld, welches eine Magnetfeldachse aufweist, welche die Symmetrieachse der Feldlinien des Magnetfeldes bildet. Unter der Bauteilachse soll die Achse des beweglichen Bauteiles verstanden werden, welche eine Referenzachse für die Nulllage des Bauteiles gegenüber Winkelbewegungen nach der einen oder anderen Seite darstellt. Handelsübliche Magneten weisen in der Regel eine Abweichung der Magnetfeldachse gegenüber der geometrischen Achse des Magneten, also der Magnetachse auf, wobei die Abweichung in einem Bereich von Plus/minus 5° liegen kann. Für eine exakte, möglichst fehlerfreie Messung einer Winkelauslenkung des Bauteiles aus der Nulllage ist es erforderlich, dass die Magnetfeldachse mit der Referenzachse, d. h. der Bauteilachse in der Nulllage übereinstimmt. Damit wird erreicht, dass sich das Magnetfeld respektive die Magnetfeldachse nach beiden Seiten oder in entgegen gesetzten Richtungen um den gleichen Winkelbetrag bewegt wie das Bauteil.

Der Magnet ist als zylindrischer Körper und die Magnetachse als Zylinderachse ausgebildet. Magnetkörper mit Zylinderform lassen sich einfach herstellen, d.h. formen und magnetisieren, wobei sich ein radialsymmetrisches Magnetfeld mit radialsymmetrisch angeordneten Feldlinien ergibt.

Nach einer nicht-erfindungsgemäßen Ausführungsform ist die Magnetachse gegenüber der Bauteilachse verkippt angeordnet, und zwar in dem Maße, dass die Magnetfeldachse mit der Bauteilachse übereinstimmt. Vorzugsweise ist die Magnetachse um den Betrag des Abweichwinkels verkippt. Der Abweichwinkel ergibt sich aus der Fehlstellung zwischen Magnetfeldachse und Magnetachse für den in das Bauteil einzubauenden Magneten.

Nach einer weiteren nicht-erfindungsgemäßen Ausführungsform ist die Magnetachse achsparallel zur Bauteilachse versetzt angeordnet, und zwar indem Maße bzw. mit einem Versatz, dass die Magnetfeldachse mit der Bauteilachse übereinstimmt. Vorzugsweise ist der Achsversatz an den Abweichwinkel zwischen Magnetachse und Magnetfeldachse angepasst. Durch den Achsversatz rückt der Magnet näher an die Wandung der Ausnehmung des Bauteils, was zu einer Verkippung oder Verlagerung der Magnetfeldachse führt. Durch die exzentrische Anordnung des Magneten in der Aufnahmeöffnung des Bauteiles ergibt sich eine unsymmetrische Beeinflussung des Magnetfeldes, so dass der Abweichwinkel kompensiert wird.

Erfindungsgemäß ist der Magnet, vorzugsweise ein zylinderförmiger Magnet, koaxial, d. h. zentrisch in der Aufnahmeöffnung des Bauteiles angeordnet. Zur Kompensation einer Abweichung des Magnetfeldes bzw. einer Fehlstellung der Magnetfeldachse sind Kompensationskörper im Umfangsbereich angeordnet. Die Kompensationskörper, welche aus einem magnetisch leitfähigen Material bestehen und nur bereichsweise auf dem Umfang angeordnet sind, haben die Wirkung, dass das Magnetfeld in der Weise verändert wird, dass die Magnetfeldachse ihre Lage verändert und in die Bauteilachse verlagert wird.

Nach einer weiteren bevorzugten Ausführungsform ist der Magnet von einem ringförmigen Kunststoffgehäuse umgeben, in welchem die Kompensationskörper an unterschiedlichen Stellen des Umfanges deponiert werden können. Das Kunststoffgehäuse stellt somit ein Magazin dar, welches nur auf Teilen des Umfanges bestückt wird, vorzugsweise diametral zu der Lage der Abweichung der Magnetfeldachse.

Nach einer weiteren bevorzugten Ausführungsform sind die Kompensationskörper als Stifte oder Drahteinlagen ausgebildet, womit sich eine feine Dosierung zur Beeinflussung des Magnetfeldes erreichen lässt.

Nach einer weiteren bevorzugten Ausführungsform ist das Bauteil als Kugelzapfen eines Kugelgelenks oder als Kugelhülse eines Kugelhülsengelenks ausgebildet. In beiden Fällen dient der Magnetfeldsensor zur Winkelmessung. Bei einem Kugelzapfen entspricht die Bauteilachse der Längsachse des Kugelzapfens. Bei einer Kugelhülse würde die Bauteilachse senkrecht zur Längsachse der Kugelhülse verlaufen.

Nach einer weiteren bevorzugten Ausführungsform weist das Kugel- oder das Kugelhülsengelenk jeweils ein Gelenkgehäuse auf, in welchem sich ein Magnetfeld empfindliches Sensorelement im Wirkungsbereich des Magnetfeldes befindet. Somit führt eine Winkelbewegung der Kugel oder der Kugelhülse zu einem Signal in dem Sensorelement und damit zu einer Winkelanzeige.

Nach einem weiteren Aspekt der Erfindung sind bei einem Verfahren zur Montage eines Magneten eines Magnetfeldsensors folgende Verfahrensschritte vorgesehen: Zunächst wird ein handelsüblicher Magnet für den Einbau in das Bauteil vorgesehen, wobei der Magnet in der Regel eine Abweichung der Magnetfelsachse gegenüber der Magnetachse aufweist. Im folgenden Verfahrensschritt wird der Magnet im Hinblick auf eine Abweichung, gegebenenfalls die Lage und die Stärke der Abweichung, d. h. einerseits den Umfangswinkel und andererseits den Abweichwinkel zwischen Magnetachse und Magnetfeldachse überprüft. Im nächsten Verfahrensschritt wird der Magnet von einer Montagevorrichtung aufgenommen und im Bauteil, d. h. in einer im Bauteil vorgesehenen Aufnahmeöffnung positioniert, wobei gleichzeitig eine Korrektur des Abweichwinkels in der Weise vorgenommen wird, dass die Magnetfeldachse mit der Bauteilachse übereinstimmt. Die Erfassung der Fehlstellung am Magneten und die anschließende Korrektur der Fehlstellung beim Einbau des Magneten in das Bauteil werden somit in einer Arbeitsfolge ohne Zwischenschritte durchgeführt.

Eine Vorrichtung zur Durchführung des Montageverfahrens kann einen Schwenkarm aufweisen, welcher einen ersten gelenkig angeordneten Schenkel und einen zweiten gegenüber dem ersten Schenkel abgewinkelten Schenkel mit einem Greifkopf zur Aufnahme des Magneten aufweist. Über die gelenkige Anordnung kann der Abweichwinkel beim Einbau des Magneten korrigiert werden, und durch den Greifkopf wird der Magnet erfasst und im Bauteil derart positioniert, dass der Abweichwinkel korrigiert ist und die Magnetfeldachse mit der Bauteilachse übereinstimmt.

Im Folgenden werden Zeichnungen näher beschrieben, wobei sich aus der Beschreibung und/oder der Zeichnung weitere Merkmale und/oder Vorteile ergeben können. Es zeigen
- Fig. 1a: einen Magneten mit einem Magnetfeld im Sollzustand,
- Fig. 1b: einen Magneten mit einem Magnetfeld, welches eine Fehlstellung der Magnetfeldachse aufweist,
- Fig. 2a: eine Vorrichtung zur Vermessung einer Winkelabweichung zwischen Magnet- und Magnetfeldachse (Feldwinkelfehler) eines Magneten,
- Fig. 2b: Montage des Magneten, korrigiert um den Feldwinkelfehler, in verkippter Position im Bauteil,
- Fig. 3a: Vorrichtung gemäß Fig. 2a zur Vermessung des Feldwinkelfehlers,
- Fig. 3b: Montage des Magneten, korrigiert um den Feldwinkelfehler, in achsparalleler, außermittiger Position im Bauteil,
- Fig. 4a: Vermessung des Feldwinkelfehlers eines Magneten und
- Fig. 4b: Montage des Magneten mit Korrektur des Feldwinkelfehlers durch Stahleinlagen in Kunststoffgehäuse.

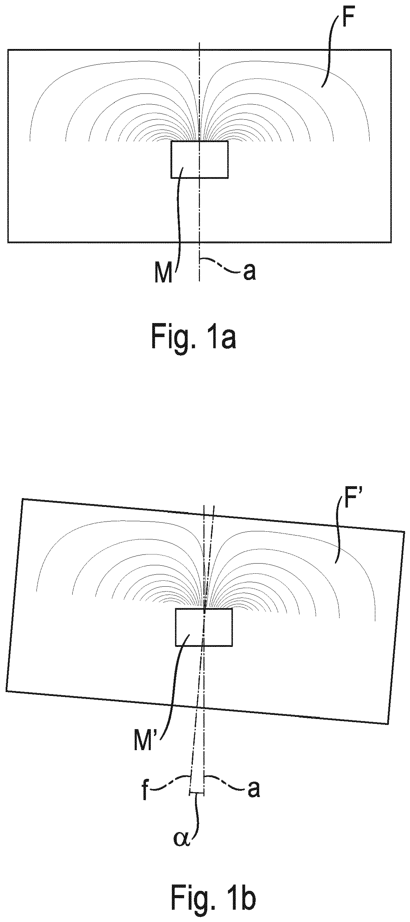

Fig. 1a zeigt einen Magneten M mit einer Magnetachse a, wobei der Magnet M vorzugsweise zylinderförmig ausgebildet ist und die Magnetachse a der Zylinderachse entspricht. Grundsätzlich ist die Magnetachse a die geometrische Achse des Magneten M. Der Magnet M erzeugt ein Magnetfeld F, dessen Feldlinienverlauf symmetrisch zur Magnetachse a angeordnet ist, d. h. die Magnetfeldachse fällt mit der Magnetachse a zusammen. Die Darstellung des Magnetfeldes F und des Magneten M entspricht somit einem Sollzustand, wie er für einen Magnetfeldsensor verlangt wird.

Fig. 1b zeigt einen handelsüblichen Magneten M' mit einer Magnetachse a, welche - wie zuvor erwähnt - der geometrischen Achse des Magneten M' entspricht. Der Magnet M' erzeugt ein Magnetfeld F', welches eine Magnetfeldachse f aufweist, die gegenüber der Magnetachse a um einen Abweichwinkel α geneigt ist. Das Magnetfeld F' ist somit nicht symmetrisch zur Magnetachse a angeordnet, so dass die Magnetachse a und die Magnetfeldachse f auseinanderfallen. Der Abweichwinkel α wird im Folgenden auch als Feldwinkelfehler α bezeichnet. Bei dem handelsüblichen Magneten M' treten herstellungsbedingt Feldwinkelfehler im Bereich von plus/minus 5° auf. Werden derartige Magnete mit einem Feldwinkelfehler in Magnetfeldsensoren, welche zur Winkelmessung eingesetzt werden, verbaut, so ist das Ergebnis der Messung mit einem Winkelfehler behaftet. Die Erfindung zielt darauf ab, derartige Messfehler zu vermeiden.

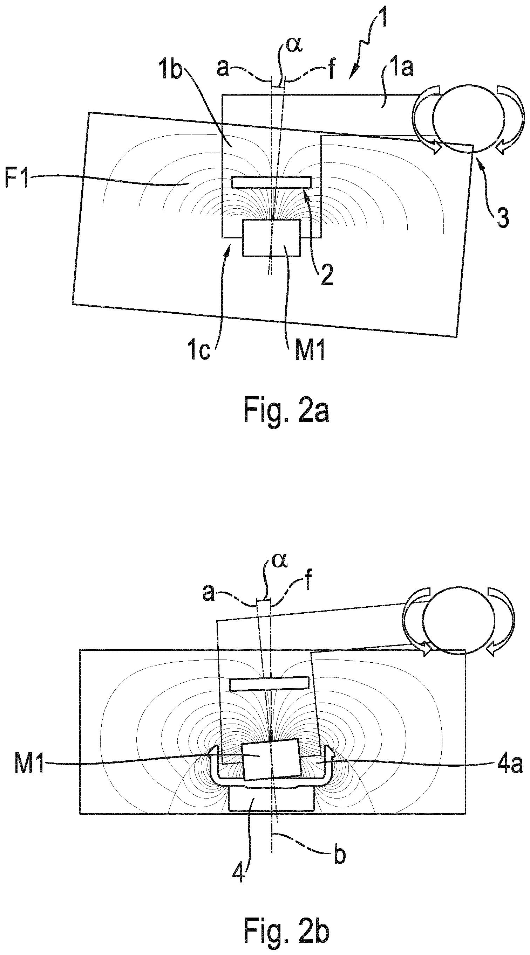

Fig. 2a zeigt eine Vorrichtung 1 zur Aufnahme, Vermessung und Montage eines Magneten M1, welcher ein mit einem Feldwinkelfehler α behaftetes Magnetfeld F1 erzeugt. Die geometrische Achse des zylinderförmig ausgebildeten Magneten M1, d. h. die Magnetachse a, bildet mit der Achse des Magnetfeldes F1, d. h. der Magnetfeldachse f, den Abweichwinkel α, auch Feldwinkelfehler α genannt. Die Vorrichtung 1 weist ein Sensorelement 2 auf, welches den Feldwinkelfehler α erfasst. Die Vorrichtung 1 ist über ein Gelenk 3 schwenkbar angeordnet und weist einen in der Zeichnung etwa horizontal verlaufenden ersten Schenkel 1a sowie einen in der Zeichnung etwa vertikal verlaufenden zweiten Schenkel 1b auf, in welchem das Sensorelement 2 angeordnet ist. Der zweite Schenkel 1b weist stirnseitig einen Greifkopf 1c auf, in welchem der Magnet M1 aufgenommen ist.

Fig. 2b zeigt die schwenkbare Vorrichtung 1 bei der Montage des Magneten M1 in einem Bauteil 4, welches eine Aufnahmeöffnung 4a für den Magneten M1 aufweist. Das Bauteil 4 kann vorzugsweise als Kugelzapfen 4 eines Kugelgelenks, wie es beispielsweise durch die DE 10 2004 039 781 A1 der Anmelderin bekannt wurde, ausgebildet sein. Das Bauteil 4 respektive der Kugelzapfen 4 weist eine Bauteilachse b respektive eine Kugelzapfenachse b auf. Wie aus der Darstellung ersichtlich, ist die Vorrichtung 1 im Vergleich zu Fig. 2a verschwenkt, so dass die Magnetachse a gegenüber der Bauteilachse b verkippt ist, und zwar um den Feldwinkelfehler α. Dies hat zur Folge, dass die Magnetfeldachse f mit der Bauteilachse b zusammenfällt. In der Zeichnung sind also Magnetfeldachse f und Bauteilachse b senkrecht angeordnet. Die verkippte Position des Magneten M1 kann durch Verkleben des Magneten M1 mit dem Bauteil 4 fixiert werden. Neben der Verkippung kann auch der radiale Versatz über die Vorrichtung 1, insbesondere den Greifkopf 1c des zweiten Schenkels 1b eingestellt werden.

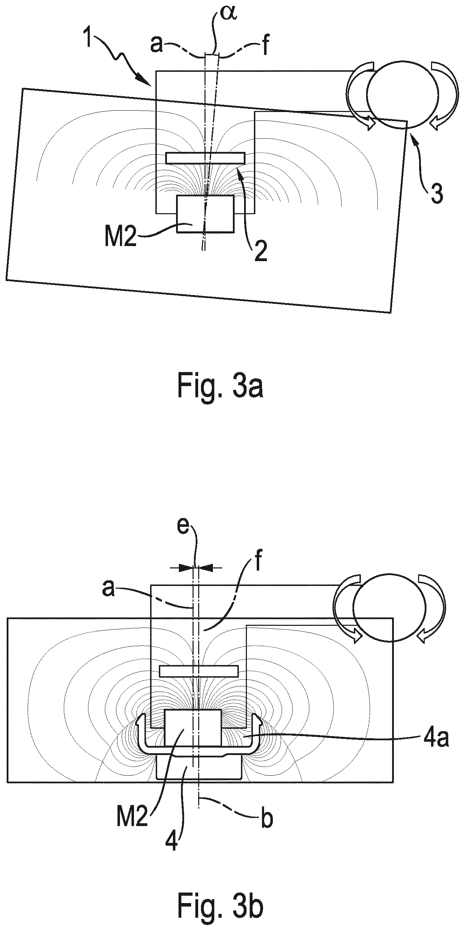

Fig. 3a zeigt eine weitere Ausführungsform der Erfindung zur Kompensation eines Feldwinkelfehlers bei der Montage eines Magneten M2. Fig. 3a entspricht der Fig. 2a und zeigt die mittels des Gelenks 3 schwenkbar angeordnete Vorrichtung 1 zur Vermessung des Feldwinkelfehlers α. Die Magnetachse ist mit a und die Magnetfeldachse mit f bezeichnet. Der Feldwinkelfehler α, d. h. die Neigung des Magnetfeldes wird über das Sensorelement 2 erfasst.

Fig. 3b zeigt die Montage des Magneten M2 mittels der Vorrichtung 1 in einer Öffnung 4a des Bauteiles 4 respektive des Kugelzapfens 4, welcher die Zapfen- bzw. Bauteilachse b aufweist. Aus der Darstellung ist erkennbar, dass die Magnetachse a achsparallel zur Bauteilachse b versetzt ist, und zwar um den Versatz e. Der Magnet M2 ist somit außermittig in der Aufnahmeöffnung, ausgebildet als Sacklochbohrung 4a mit der Achse b, angeordnet. Der Vorteil dieser Ausführungsform gegenüber der Ausführungsform gemäß Fig. 2b besteht darin, dass der Magnet M2 plan auf dem Boden der Aufnahmeöffnung 4a aufliegt.

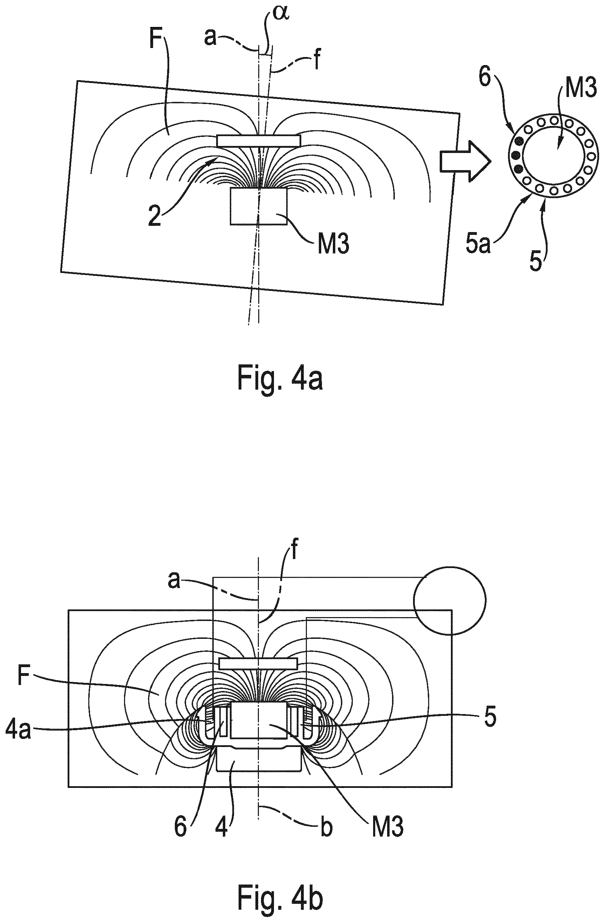

Fig. 4a zeigt einen Magneten M3 mit einem Magnetfeld F, dessen Magnetfeldachse f gegenüber der Magnetachse a geneigt ist und einen Feldwinkelfehler α aufweist, welcher durch das Sensorelement 2 erfasst wird. Auf der rechten Seite von Fig. 4a ist der Magnet M3 in einer Draufsicht dargestellt und in einem ringförmigen Kunststoffgehäuse 5 angeordnet, welches eine Vielzahl von auf dem Umfang angeordneten, zylinderförmig ausgebildeten Kammern 5a aufweist. In einigen der Kammern 5a (in der Zeichnung sind es drei Kammern) sind Kompensationskörper 6, ausgebildet als Stifte oder Drahteinlagen 6, eingesetzt. Die Kompensationskörper 6 sind aus einem magnetisch leitfähigen Material, vorzugsweise aus Stahl hergestellt. Die Stahlstifte 6 haben die Wirkung, dass das Magnetfeld F gemäß Fig. 4a verzerrt und damit der Feldwinkelfehler α korrigiert wird.

Fig. 4b zeigt den Magneten M3 mit Kunststoffgehäuse 5 einschließlich Kompensationskörper 6, eingebaut in der Aufnahmeöffnung 4a des Bauteiles 4 mit der Bauteilachse b. Man erkennt aus der Darstellung, dass das Magnetfeld F symmetrisch zur Bauteilachse b angeordnet ist und die Magnetfeldachse f sowie die Magnetachse a mit der Bauteilachse b zusammenfallen. Vorteilhaft bei dieser Ausführungsform ist, dass der Magnet M3 zentrisch und plan verbaut oder bei Bedarf radial mit einem Versatz korrigiert werden kann.

Das Bauteil 4 kann auch als Kugelhülse eines Kugelhülsengelenks, wie es beispielsweise durch die DE 103 58 763 A1 der Anmelderin bekannt wurde, ausgebildet sein.

### Bezugszeichen

- 1: Vorrichtung
- 1a: erster Schenkel
- 1b: zweiter Schenkel
- 1c: Greifkopf
- 2: Sensorelement
- 3: Gelenk
- 4: Bauteil/Kugelzapfen
- 4a: Aufnahmeöffnung/Bohrung
- 5: Kunststoffgehäuse
- 5a: Kammer
- 6: Kompensationskörper/Stahlstift

- a: Magnetachse
- b: Bauteilachse
- e: Achsversatz
- f: Magnetfeldachse
- F: Magnetfeld
- F': Magnetfeld mit Fehlstellung
- F1: Magnetfeld
- M: Magnet
- M': Magnet (handelsüblich)
- M1: Magnet
- M2: Magnet
- M3: Magnet
- α: Abweichwinkel/Feldwinkelfehler

## Patentansprüche

1. Magnetfeldsensor mit einem ein Magnetfeld (F) mit einer Magnetfeldachse (f) erzeugenden Magneten (M), welcher eine Magnetachse (a) aufweist und in einem um mindestens eine Achse beweglichen Bauteil (4) mit einer Bauteilachse (b) aufgenommen ist wobei der Magnet (M) als zylindrischer Körper (M1, M2, M3) und die Magnetachse (a) als Zylinderachse (a) ausgebildet sind und sich ein radialsymmetrisches Magnetfeld mit radialsymmetrisch angeordneten Feldlinien ergibt, **dadurch gekennzeichnet, dass** die Magnetfeldachse (f) aufgrund fertigungsbedingter Abweichungen von der Magnetachse (a) abweicht und der Magnet (M1, M2, M3) zum Korrigieren der Abweichung derart in dem Bauteil (4) aufgenommen ist, dass die Magnetfeldachse (f) weitestgehend mit der Bauteilachse (b) übereinstimmt, wobei die Magnetachse (a) des Magneten (M3) mit der Bauteilachse (b) übereinstimmt und im Umfangsbereich des Magneten (M3) Kompensationskörper (6) aus magnetisch leitfähigem Material angeordnet sind.

2. Magnetfeldsensor nach Anspruch 1, **dadurch gekennzeichnet, dass** der Magnet (M3) in einem ringförmigen Kunststoffgehäuse (5) angeordnet ist, in welchem die Kompensationskörper (6) deponierbar sind.

3. Magnetfeldsensor nach Anspruch 2, **dadurch gekennzeichnet, dass** das Kunststoffgehäuse (5) achsparallel zur Magnetachse (a) angeordnete, über den Umfang verteilte Kammern (5a) zur Aufnahme der Kompensationskörper (6) aufweist.

4. Magnetfeldsensor nach Anspruch 1, 2 oder 3, **dadurch gekennzeichnet, dass** die Kompensationskörper (6) als Stifte oder Drahteinlagen ausgebildet sind.

5. Magnetfeldsensor nach einem der vorhergehenden Ansprüche, **dadurch gekennzeichnet, dass** das Bauteil als Kugelzapfen (4) eines Kugelgelenks oder als Kugelhülse eines Kugelhülsengelenks ausgebildet ist.

6. Magnetfeldsensor nach Anspruch 5, **dadurch gekennzeichnet, dass** das Kugel- oder Kugelhülsengelenk ein Gelenkgehäuse aufweist, und dass in dem Gelenkgehäuse ein Magnetfeld empfindliches Sensorelement im Bereich des Magnetfeldes (F) des Magneten (M) angeordnet ist.

7. Verfahren zur Montage eines Magneten (M) eines Magnetfeldsensors nach einem der vorhergehenden Ansprüche, **gekennzeichnet durch** folgende Verfahrensschritte:
a) Bereitstellen eines handelsüblichen Magneten (M1, M2, M3),
b) Überprüfung des Magneten (M1, M2, M3) auf fertigungsbedingte Abweichungen, Messung einer eventuellen Abweichung der Magnetfeldachse (f) von der Magnetachse (a) und Feststellung des Abweichwinkels (α),
c) Aufnahme des Magneten (M1, M2, M3) mit einer Montagevorrichtung (1) und Positionierung des Magneten (M1, M2, M3) bei gleichzeitiger Korrektur des Abweichwinkels (α) im Bauteil (4) und
d) Fixierung des Magneten (M1, M2, M3) im Bauteil (4), so dass die Magnetfeldachse (f) mit der Bauteilachse (b) übereinstimmt.

## Claims

1. Magnetic field sensor having a magnet (M), which generates a magnetic field (F) having a magnetic field axis (f) and which has a magnet axis (a) and is received in a component (4), which is movable about at least one axis and has a component axis (b), wherein the magnet (M) is in the form of a cylindrical body (M1, M2, M3) and the magnet axis (a) is in the form of a cylinder axis (a) and a radially symmetrical magnetic field with radially symmetrically arranged field lines is produced, **characterized in that** the magnetic field axis (f) deviates from the magnet axis (a) on account of production-related deviations and the magnet (M1, M2, M3), for the purpose of correcting the deviation, is received in the component (4) in such a way that the magnetic field axis (f) largely corresponds to the component axis (b), wherein the magnet axis (a) of the magnet (M3) corresponds to the component axis (b) and compensation bodies (6) composed of magnetically permeable material are arranged in the peripheral region of the magnet (M3).

2. Magnetic field sensor according to Claim 1, **characterized in that** the magnet (M3) is arranged in an annular plastic housing (5) in which the compensation bodies (6) can be deposited.

3. Magnetic field sensor according to Claim 2, **characterized in that** the plastic housing (5) has chambers (5a), which are arranged axially parallel to the magnet axis (a) and are distributed over the periphery, for receiving the compensation bodies (6).

4. Magnetic field sensor according to Claim 1, 2 or 3, **characterized in that** the compensation bodies (6) are in the form of pins or wire inserts.

5. Magnetic field sensor according to one of the preceding claims, **characterized in that** the component is in the form of a ball pivot (4) of a ball joint or in the form of a ball sleeve of a ball sleeve joint.

6. Magnetic field sensor according to Claim 5, **characterized in that** the ball joint or ball sleeve joint has a joint housing, and **in that** a magnetic field-sensitive sensor element is arranged in the joint housing in the region of the magnetic field (F) of the magnet (M) .

7. Method for mounting a magnet (M) of a magnetic field sensor according to one of the preceding claims, **characterized by** the following method steps:
a) providing a commercially available magnet (M1, M2, M3),
b) checking the magnet (M1, M2, M3) for production-related deviations, measuring any deviation in the magnetic field axis (f) from the magnet axis (a), and determining the deviation angle (α),
c) receiving the magnet (M1, M2, M3) with a mounting device (1) and positioning the magnet (M1, M2, M3) with simultaneous connection of the deviation angle (α) in the component (4), and
d) fixing the magnet (M1, M2, M3) in the component (4), so that the magnetic field axis (f) corresponds to the component axis (b).

## Revendications

1. Capteur de champ magnétique, comprenant un aimant (M) générant un champ magnétique (F) pourvu d'un axe de champ magnétique (f), qui présente un axe d'aimant (a) et est logé dans un composant mobile autour d'au moins un axe et pourvu d'un axe de composant (b), dans lequel l'aimant (M) est réalisé comme un corps cylindrique (M1, M2, M3), et l'axe d'aimant (a) est réalisé comme un axe de cylindre (a), et il en résulte un champ magnétique à symétrie radiale pourvu de lignes de champ disposées en symétrie radiale,
**caractérisé en ce que** l'axe de champ magnétique (f) s'écarte de l'axe magnétique (a) en raison d'écarts dus à la fabrication, et l'aimant (M1, M2, M3) servant à corriger l'écart est logé dans le composant (4) de telle sorte que l'axe de champ magnétique (f) coïncide substantiellement avec l'axe de composant (b), dans lequel l'axe d'aimant (a) de l'aimant (M3) coïncide avec l'axe de composant (b), et des corps de compensation (6) composés d'un matériau magnétiquement conducteur sont disposés dans la zone périphérique de l'aimant (M3).

2. Capteur de champ magnétique selon la revendication 1, **caractérisé en ce que** l'aimant (M3) est disposé dans un boîtier plastique annulaire (5) dans lequel les corps de compensation (6) peuvent être déposés.

3. Capteur de champ magnétique selon la revendication 2, **caractérisé en ce que** le boîtier plastique (5) présente des chambres (5a) pour loger les corps de compensation (6), réparties sur la périphérie et disposées de manière parallèle à l'axe d'aimant (a).

4. Capteur de champ magnétique selon la revendication 1, 2 ou 3, **caractérisé en ce que** les corps de compensation (6) sont réalisés sous forme de broches ou d'armatures.

5. Capteur de champ magnétique selon l'une quelconque des revendications précédentes, **caractérisé en ce que** le composant est réalisé comme un pivot à rotule (4) d'un joint à rotule ou comme une douille sphérique d'une articulation à douille sphérique.

6. Capteur de champ magnétique selon la revendication 5, **caractérisé en ce que** le joint à rotule ou l'articulation à douille sphérique présente un carter d'articulation, et **en ce qu'**un élément capteur sensible au champ magnétique est disposé dans le carter d'articulation au niveau du champ magnétique (F) de l'aimant (M).

7. Procédé de montage d'un aimant (M) d'un capteur de champ magnétique selon l'une quelconque des revendications précédentes, **caractérisé par** les étapes de procédé suivantes consistant à :
a) fournir un aimant usuel (M1, M2, M3),
b) contrôler l'aimant (M1, M2, M3) quant à des écarts dus à la fabrication, mesurer un écart éventuel de l'axe de champ magnétique (f) par rapport à l'axe d'aimant (a) et constater l'angle d'écart (a),
c) loger l'aimant (M1, M2, M3) à l'aide d'un dispositif de montage (1) et positionner l'aimant (M1, M2, M3) tout en corrigeant l'angle d'écart (α) dans le composant (4), et
d) fixer l'aimant (M1, M2, M3) dans le composant (4) de sorte que l'axe de champ magnétique (f) coïncide avec l'axe de composant (b).
